# EUROPÄISCHE PATENTSCHRIFT

(11) **EP 3 673 231 B1**
(45) Veröffentlichungstag und Bekanntmachung des Hinweises auf die Patenterteilung: **26.05.2021**
(21) Anmeldenummer: 18773075.9
(22) Anmeldetag: 23.08.2018
(51) Int. Cl.: G01B 7/02, G01B 7/00, G01R 33/00, G01V 3/10, H04B 5/00, H04B 15/00, B61H 9/02, H03K 17/95, G01D 5/22

(54) **INDUKTIVER SENSOR**
INDUCTIVE SENSOR
CAPTEUR INDUCTIF

(30) Priorität: 25.08.2017 AT 507112017
(43) Veröffentlichungstag der Anmeldung: 01.07.2020
(73) Patentinhaber: Innova Patent GmbH, 6922 Wolfurt (AT)
(72) Erfinder: HOFMAYR, Christoph, 6850 Dornbirn (AT); MOHNI, Adrian, 9014 St. Gallen (CH); NAGEL, Helmut, 6973 Höchst (AT)
(74) Vertreter: Patentanwälte Pinter & Weiss OG
(86) Internationale Anmeldenummer: PCT/EP2018/072804
(87) Internationale Veröffentlichungsnummer: WO 2019/038397

(56) Entgegenhaltungen:
- AT-B- 204 596
- DE-T2- 69 717 188
- US-A- 5 864 229

## Beschreibung

Die gegenständliche Erfindung betrifft einen induktiven Sensor für eine Seillagenüberwachung eines Förderseiles einer Seilbahnanlage, wobei der Sensor eine Sensorspule mit zwei Spulenanschlüssen und eine Sensorauswerteeinheit, die mit den beiden Spulenanschlüssen verbunden ist, umfasst, sowie eine Seilbahnanlage umfassend ein Förderseil und einen solchen induktiven Sensor.

Berührungslose induktive Sensoren werden oftmals für die Abstandsmessung verwendet. Dabei kann der Sensor als Näherungssensor ausgeführt sein, der ab einem bestimmten Abstand des Sensors zum gemessenen Objekt anschlägt oder es kann mit dem Sensor der Abstand zum Objekt auch als Wert ausgegeben werden. Solche Sensoren dienen häufig zur Überwachung bestimmter Funktionalitäten in Maschinen und Anlagen.

Ein induktiver Sensor nutzt eine Spule zur Erzeugung eines elektromagnetischen Feldes, das vom gemessenen Objekt beeinflusst wird. Die Beeinflussung kann messtechnisch erfasst und ausgewertet werden. Ein Ausführungsbeispiel ist ein als Wirbelstromsensor ausgeführter induktiver Sensor. Dabei erzeugt ein Oszillator ein elektromagnetisches Wechselfeld, das aus der aktiven Fläche des Sensors austritt. In jedem elektrisch leitfähigen Objekt in der Nähe der aktiven Fläche werden je nach Abstand des Objekts zur aktiven Fläche Wirbelströme induziert, welche dem Oszillator Energie entziehen und als Leistungsverluste am Spuleneingang erfasst werden können.

Eine spezielle Anwendung für einen induktiven Sensor ist die Seillagenüberwachung des umlaufenden Förderseiles einer Seilbahnanlage. Das Förderseil wird zur Führung entlang der Strecke an den Seilbahnstützen über Rollen einer Rollenbatterie geführt. Die Lage des Förderseils relativ zu den Rollen der Rollenbatterie kann dabei mit einem induktiven Sensor überwacht werden. Dabei kann sowohl die seitliche Auslenkung des Förderseils, was beispielsweise auf ein Herausspringen des Förderseils aus der Rolle hindeuten kann, erkannt werden, als auch ein zu geringer Abstand zur Drehachse der Rolle, was auf das Hineinfressen des Förderseils in die Lauffläche der Rolle, beispielsweise bei einer blockierenden Rolle, hinweist. Die Seillagenüberwachung ist eine wichtige Sicherheitsfunktion einer Seilbahnanlage und kann zu einer Reduzierung der Fördergeschwindigkeit oder zu einer Zwangsabschaltung der Seilbahn führen. Bei der Seillagenüberwachung dient das als Stahlseil ausgeführte Förderseil als zu messendes Objekt und der Sensor ist stationär im Bereich des Förderseils angeordnet. Diese Anwendung benötigt eine hohe Sensitivität des induktiven Sensors, um die Seillage mit ausreichender Genauigkeit erfassen zu können.

Der Nachteil solcher induktiver Sensoren liegt darin, dass jedes äußere (elektro)magnetische Wechselfeld im Umfeld des Sensors eine elektrische Spannung in der Spule des Sensors induziert. Diese von außen eingeprägte Überspannung stört natürlich auch die Messung. Abgesehen davon muss der Sensor natürlich auch eine ausreichende Überspannungsfestigkeit aufweisen. Funk- oder Radiowellen im Umfeld des Sensors werden nur niedrige Spannungen induzieren und werden vorrangig die Messung negativ beeinflussen und die Sensitivität der Messung reduzieren. Bei einem Blitzeinschlag in das Förderseil der Seilbahn kommt es hingegen zu einem Stromfluss im Förderseil, wodurch starke magnetische Felder um das Förderseil erzeugt werden. Durch solche Blitzströme kann es zum Einkoppeln sehr hoher elektrischer Spannungen in die Spule des Sensors kommen. Untersuchungen haben gezeigt, dass bei typischen Blitzströmen induzierte Spannungen von mehreren Kilovolt an den Abgängen der Spule auftreten können. Diese hohen Spannungen können zur Zerstörung der Spule und/oder zur Zerstörung der nachfolgenden Sensorelektronik führen.

Die DE 10 2015 221342 A1 und US 5 581 180 A beschreiben einen induktiven Sensor für eine Seillagenüberwachung. Die AT 204 596 B hingegen beschreibt eine Vorrichtung, welche eine ortsfeste Induktionsspule umfasst, die magnetische Einlagen in einem Förderseil erkennt. Die magnetischen Einlagen ermöglichen es, die Position des Förderseils entlang der Förderrichtung zu erkennen. Durchläuft die magnetische Einlage die Induktionsspule, so wird ein Relais betätigt, welches zur Steuerung eines Bremsvorgangs dient, womit eine Einfahrt in eine Station erkannt wird, um eine mit dem Seil verbundene Fahrgastkabine abzubremsen. Damit ist in der AT 204 596 B jedoch keine Seillagenüberwachung und insbesondere keine Blitzschutzmaßnahme offenbart.

Es besteht natürlich die Möglichkeit einen elektronischen Blitzschutz bzw. Schutz gegen Überspannung im Sensor zu implementieren, was aber wiederum den Messkreis stört und damit die Sensitivität des Sensors einschränkt.

Es ist daher eine Aufgabe der Erfindung einen induktiven Sensor anzugeben, der unempfindlich gegen äußere elektromagnetische Felder ist.

Diese Aufgabe wird dadurch gelöst, indem die Sensorspule mit einem ersten Wicklungsteil und einem damit verbundenen zweiten Wicklungsteil ausgeführt ist, wobei der erste Wicklungsteil und der zweite Wicklungsteile gegensinnig gewickelt sind und der erste Wicklungsteil mit einem ersten Spulenanschluss verbunden ist und der zweite Wicklungsteil mit einem zweiten Spulenanschluss verbunden ist und wobei die Sensorspule ausgestaltet ist, in Wirkverbindung mit dem Förderseil zu treten und die Sensorauswerteeinheit ausgestaltet ist, eine Lageänderung des Förderseils relativ zum Sensor zu erfassen und auszuwerten. Durch den gegensinnigen Wicklungssinn kompensieren sich in den Wicklungsteilen induzierte Spannungen zumindest teilweise, sodass an den Spulenanschlüssen nur geringe bis gar keine Überspannungen auftreten können. Damit wird die Messung nicht oder nur unwesentlich gestört, sodass eine hohe Sensitivität der Messung erreicht werden kann. Ebenso sind keine weiteren Maßnahmen für den Überspannungsschutz gegen Überspannung, die von äußeren elektromagnetischen Feldern hervorgerufen werden, notwendig, die den Messkreis stören könnten. Damit kann der Sensor auch gegen sehr hohe äußere elektromagnetische Felder geschützt werden, wie sie z.B. bei Blitzströmen durch Leitern auftreten können. Damit ist ein solcher Sensor insbesondere auch für Anwendungen im Außenbereich geeignet. Eine besonders vorteilhafte Anwendung für einen solchen Sensor ist daher die Verwendung in einer Seilbahnanlage, z.B. für die Seillagenüberwachung des Förderseils.

In einer einfachen Ausgestaltung ist die Sensorspule durchgehend achterförmig gewickelt ausgeführt. Eine solche Sensorspule lässt sich besonders einfach herstellen.

Besonders vorteilhaft ist eine Sensorspule mit eine erster Einzelspule als erster Wicklungsteil die in Serie mit einer zweiten Einzelspule als zweiter Wicklungsteil verbunden ist. Mit dieser Ausführung können hohe Differenzspannungen zwischen einzelnen Wicklungen der Sensorspule vermieden werden, womit die Gefahr von Spannungsdurchschlägen reduziert ist.

Wenn die erste Einzelspule und die zweite Einzelspule schneckenförmig gewickelt sind, kann eine besonders flache Sensorspule realisiert werden, was für die Verwendung im Sensor vorteilhaft ist.

Die gegenständliche Erfindung wird nachfolgend unter Bezugnahme auf die Figuren 1 bis 5 näher erläutert, die beispielhaft, schematisch und nicht einschränkend vorteilhafte Ausgestaltungen der Erfindung zeigen. Dabei zeigt
Fig.1 das Funktionsprinzip eines berührungslosen induktiven Sensors,
Fig.2 eine erste Ausgestaltung einer erfindungsgemäßen Sensorspule,
Fig.3 eine weitere Ausgestaltung einer erfindungsgemäßen Sensorspule,
Fig.4 eine weitere Ausgestaltung einer erfindungsgemäßen Sensorspule und
Fig.5 die Verwendung einer erfindungsgemäßen Sensorspule zur Seillagenüberwachung in einer Seilbahnanlage.

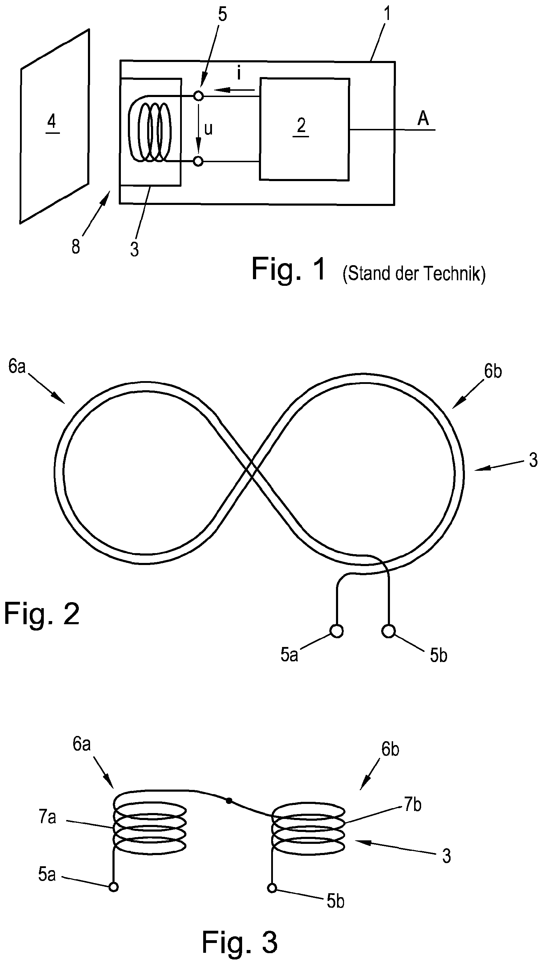

Das Prinzip eines induktiven Sensors zur Abstandsmessung ist in Fig.1 dargestellt. Eine Sensorspule 3 erzeugt ein elektromagnetisches Feld, das mit einem elektrisch leitfähigen Objekt 4 wechselwirkt. Diese Wechselwirkung kann an den Abgängen 5 der Sensorspule 3 von einer Sensorauswerteeinheit 2 erfasst und ausgewertet werden, beispielsweise über die Spulenspannung u und/oder den Spulenstrom i. Bei einer Ausführung als Wirbelstromsensor erzeugt ein Oszillator in der Sensorauswerteeinheit 2 eine hochfrequente Wechselspannung, die an die Sensorspule 3 angelegt wird und ein hochfrequentes Wechselfeld erzeugt. Dieses hochfrequente Wechselfeld erzeugt in einem Objekt 4 im Einflussbereich des Sensors 1 Wirbelströme, die dem elektromagnetischen Wechselfeld Energie entziehen, wodurch die Höhe der Schwingungsamplitude der Oszillatorspannung reduziert wird. Diese Änderung der Schwingungsamplitude wird von der Sensorauswerteeinheit 2 ausgewertet. Der Sensor 1 liefert als Ausgangssignal A entweder einen Highpegel oder Lowpegel bei Ausführung als Näherungsschalter oder das Ausgangssignal A repräsentiert ein Maß für den Abstand zwischen Sensorspule 3 und dem Objekt 4. Im letzten Fall kann das Ausgangssignal A analog sein, beispielsweise eine elektrische Spannung, oder digital.

Für die Erfindung ist es jedoch unerheblich nach welchem Prinzip der induktive Sensor 1 arbeitet oder wie die Sensorauswerteeinheit 2 ausgeführt ist oder wie ausgewertet wird oder in welcher Art das Ausgangssignal A ausgegeben wird.

Die Erfindung beruht auf einer speziellen Ausgestaltung der Sensorspule 3. Die Sensorspule 3 ist erfindungsgemäß mit einem ersten Wicklungsteil 6a und einem damit verbundenen zweiten Wicklungsteil 6b ausgeführt, wobei der erste Wicklungsteil 6a und der zweite Wicklungsteil 6b gegensinnig gewickelt sind. Ein erste Spulenanschluss 5a ist mit dem ersten Wicklungsteil 6a verbunden und ein zweiter Spulenanschluss 5b mit dem zweiten Wicklungsteil 6b. Durch den gegensinnigen Wicklungssinn der beiden Wicklungsteile 6a, 6b induzieren äußere elektromagnetische Felder in den beiden Wicklungsteilen 6a, 6b entgegengesetzte Spannungen, die sich zumindest zum Teil kompensieren. Auf diese Weise entsteht durch externe elektromagnetische Felder an den Spulenanschlüssen 5a, 5b eine wesentlich geringere Überspannung. Wenn die beiden Wicklungsteile 6a, 6b bis auf den Wicklungssinn identisch sind, dann heben sich die darin induzierten Spannungen sogar im Wesentlichen auf und es kommt zu keinen, oder nur zu äußerst geringen, Überspannungen an den Spulenanschlüssen 5a, 5b. Das gilt zumindest für ein homogenes äußeres elektromagnetisches Feld, was aber in der Regel für typische Anwendungen vorausgesetzt werden kann. Aber selbst bei einem inhomogenen äußeren Feld würden sich die beiden induzierten Spannungen zum großen Teil kompensieren.

Die Sensorspule 3 kann nun durchgehend gewickelt sein oder kann auch aus zwei in Serie verschalteten Einzelspulen bestehen.

In einer ersten Ausgestaltung nach Fig.2 ist die Sensorspule 3 durchgehend achterförmig gewickelt. Der Einfachheit halber sind in Fig.2 nur jeweils zwei Wicklungen pro Wicklungsteil 6a, 6b dargestellt, wobei die Sensorspule 3 natürlich auch mehr Wicklungen haben kann. Durch die achterförmige Wicklung haben die beiden entstehenden Wicklungsteile 6a, 6b gegensinnigen Wicklungssinn.

Ein ähnliches Ergebnis erhält man, wenn man zuerst eine Spule wickelt, die gewickelte Spule an einer Stelle zusammendrückt und dann einen der dabei entstehenden Wicklungsteile 6a gegenüber dem anderen Wicklungsteil 6b um 180° verdreht. Auf diese Weise entsteht ebenfalls eine durchgehend gewickelte achterförmige Sensorspule 3 mit zwei gegensinnig gewickelten Wicklungsteilen 6a, 6b.

Eine weitere Ausgestaltung ergibt sich, wenn zwei gegensinnig gewickelte Einzelspulen 7a, 7b in Serie verschaltet werden. Die beiden Einzelspulen 7a, 7b bilden dabei in der Sensorspule 3 jeweils einen Wicklungsteil 6a, 6b aus, wie in Fig.3 dargestellt.

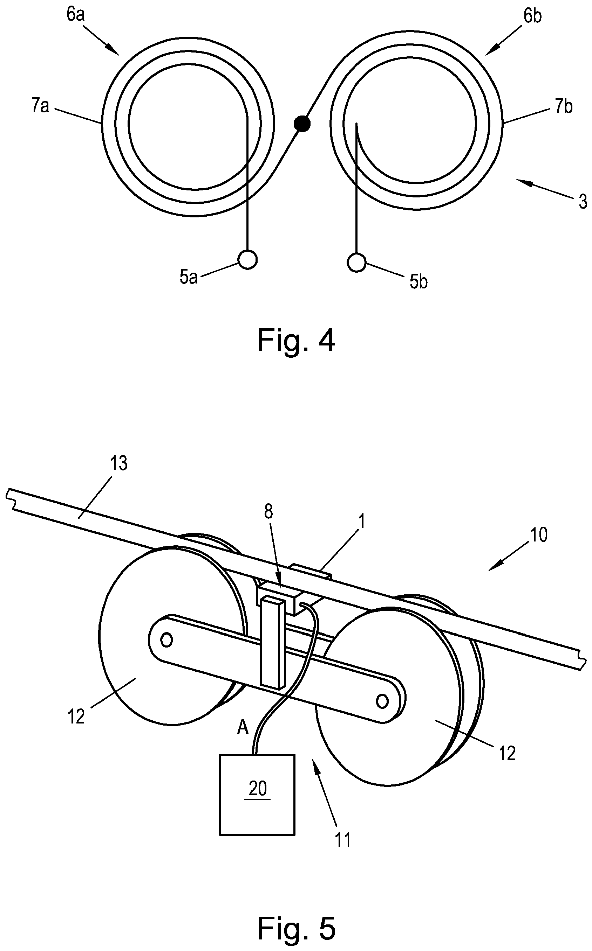

In einer besonders vorteilhaften Ausgestaltung werden die beiden die Wicklungsteile 6a, 6b ausbildenden Einzelspulen 7a, 7b schneckenförmig gewickelt, wie in Fig.4 dargestellt. Dabei sind die Wicklungen der Wicklungsteile 6a, 6b vorzugsweise in einer Ebene angeordnet. Die Wicklungsteile 6a, 6b können dabei als einlagige Schnecke gewickelt sein, oder auch als mehrlagige Schnecke. Bei einer solchen Ausgestaltung kann die Sensorspule 3 besonders flach ausgeführt werden.

Der Vorteil der Ausführung mit seriell verschalteten Einzelspulen 7a, 7b gegenüber einer durchgehend gewickelten Sensorspule 3 liegt darin, dass die Spannungsunterschiede zwischen nebeneinander liegenden Wicklungen der Sensorspule 3 immer klein sind, sodass es zu keinen unerwünschten Spannungsdurchschlägen, die die Sensorspule 3 zerstören würden, kommen kann. Bei einer achterförmigen Ausgestaltung kann es insbesondere im Bereich des Kreuzungspunktes der einzelnen Wicklungen zu großen Spannungsunterschieden zwischen einzelnen Wicklungen kommen, weshalb hier die Gefahr von Spannungsdurchschlägen höher ist und daher unter Umständen höhere Isolationsmaßnahmen getroffen werden müssen.

Um zu vermeiden, dass sich die von den Wicklungsteilen 6a, 6b erzeugten elektromagnetischen Erregungsfelder nicht gegenseitig ganz oder teilweise auslöschen, sind die beiden Wicklungsteile 6a, 6b wie in den Figuren dargestellt in einer Ebene nebeneinander, und nicht hintereinander, angeordnet. Diese Ebene wird auch als aktive Fläche 8 (Fig.1) des Sensors 1 bezeichnet, aus der die elektromagnetischen Felder austreten. Das Objekt 4 ist dabei gegenüber der aktiven Fläche 8 des Sensors 1 angeordnet, um in den Einflussbereich der elektromagnetischen Felder zu gelangen.

Der Sensor 1 kann auch in sicherheitskritischen Anwendungen eingesetzt werden, sodass der Sensor 1 auch ausgeführt sein kann, um Anforderungen an die funktionale Sicherheit (z.B. eine Sicherheitsanforderungsstufe nach IEC 61508) zu erfüllen. Beispielsweise könnte der Sensor 1 mit einer zweikanaligen Sensorauswerteeinheit 2 ausgeführt sein, wobei auch gegenseitige Überprüfungen der Kanäle vorgesehen sein können. Selbstverständlich sind auch andere oder zusätzliche bekannte Maßnahme zur Erreichung einer funktionalen Sicherheit denkbar.

Eine vorteilhafte Anwendung des erfindungsgemäßen induktiven Sensors 1 ist in einer Seillagenüberwachung einer Seilbahnanlage 10, wie in Fig.5 dargestellt. Die Seilbahnanlage 10 ist in Fig.5 nur teilweise und so weit wie notwendig dargestellt, da der grundlegende Aufbau einer Seilbahnanlage in den verschiedenen Ausgestaltungen hinreichend bekannt ist. Der Sensor 1 wird dabei beispielsweise im Bereich einer Rollenbatterie 11 an einer Seilbahnstütze mit einer Anzahl von Seilrollen 12 stationär und in berührungsloser Wirkverbindung mit einem Förderseil 13 angeordnet. Selbstverständlich kann der Sensor 1 auch an jeder anderen Stelle der Seilbahnanlage 10 zur Überwachung der Seillage des Förderseils 13 angeordnet sein. In Wirkverbindung bedeutet dabei natürlich, dass das Förderseil 13 als Objekt 4 das elektromagnetische Feld der Sensorspule 3 des Sensors 1 ausreichend beeinflusst, sodass eine Lageänderung des Förderseils 13 relativ zum Sensor 1 von der Sensorauswerteeinheit 2 erfasst und ausgewertet werden kann. Das Förderseil 13 ist dazu gegenüber der aktiven Fläche 8 des Sensors 1 angeordnet. Das Ausgangssignal A vom Sensor 1 wird an eine Seilbahnsteuereinheit 20 übermittelt und dort für die Steuerung der Seilbahnanlage 10 verwendet. Die Übermittlung kann natürlich drahtgebunden oder drahtlos erfolgen. Beispielsweise kann in Abhängigkeit vom Ausgangssignal A die Fördergeschwindigkeit des Förderseils 13 verändert werden, oder die Seilbahnanlage 10 gestoppt werden.

## Patentansprüche

1. Induktiver Sensor (1) für eine Seillagenüberwachung eines Förderseiles (13) einer Seilbahnanlage (10), wobei der Sensor (1) eine Sensorspule (3) mit zwei Spulenanschlüssen (5a, 5b) und eine Sensorauswerteeinheit (2), die mit den beiden Spulenanschlüssen (5a, 5b) verbunden ist, umfasst, **dadurch gekennzeichnet, dass** die Sensorspule (3) mit einem ersten Wicklungsteil (6a) und einem damit verbundenen zweiten Wicklungsteil (6b) ausgeführt ist, wobei der erste Wicklungsteil (6a) und der zweite Wicklungsteile (6b) gegensinnig gewickelt sind und der erste Wicklungsteil (6a) mit einem ersten Spulenanschluss (5a) verbunden ist und der zweite Wicklungsteil (6b) mit einem zweiten Spulenanschluss (5b) verbunden ist, **und dass** die Sensorspule (3) ausgestaltet ist, in Wirkverbindung mit dem Förderseil (13) zu treten und die Sensorauswerteeinheit (2) ausgestaltet ist, eine Lageänderung des Förderseils (13) relativ zum Sensor (1) zu erfassen und auszuwerten.

2. Induktiver Sensor nach Anspruch 1, **dadurch gekennzeichnet, dass** die Sensorspule (3) durchgehend achterförmig gewickelt ausgeführt ist.

3. Induktiver Sensor nach Anspruch 1, **dadurch gekennzeichnet, dass** eine erste Einzelspule (7a) als erster Wicklungsteil (6a) in Serie mit einer zweiten Einzelspule (7b) als zweiter Wicklungsteil (6b) verbunden ist.

4. Induktiver Sensor nach Anspruch 3, **dadurch gekennzeichnet, dass** die erste Einzelspule (7a) und die zweite Einzelspule (7b) schneckenförmig gewickelt sind.

5. Induktiver Sensor nach einem der Ansprüche 1 bis 4, **dadurch gekennzeichnet, dass** die beiden Wicklungsteile (6a, 6b) in einer Ebene nebeneinander angeordnet sind.

6. Seilbahnanlage umfassend ein Förderseil (13) und einen induktiven Sensor (1) nach einem der Ansprüche 1 bis 5 zur Seillagenüberwachung des Förderseiles (13).

## Claims

1. Inductive sensor (1) for monitoring the position of a traction cable (13) of a cable car system (10), the sensor (1) comprising a sensor coil (3) having two coil terminals (5a, 5b) and a sensor evaluation unit (2) which is connected to the two coil terminals (5a, 5b), **characterized in that** the sensor coil (3) is designed so as to have a first winding part (6a) and a second winding part (6b) connected thereto, the first winding part (6a) and the second winding part (6b) being wound in opposite directions and the first winding part (6a) being connected to a first coil terminal (5a) and the second winding part (6b) being connected to a second coil terminal (5b), **and in that** the sensor coil (3) is designed to be operatively connected to the traction cable (13) and the sensor evaluation unit (2) is designed to detect and evaluate a change in position of the traction cable (13) relative to the sensor (1).

2. Inductive sensor according to claim 1, **characterized in that** the sensor coil (3) is continuously wound in a figure of eight.

3. Inductive sensor according to claim 1, **characterized in that** a first single coil (7a) as the first winding part (6a) is connected in series with a second single coil (7b) as the second winding part (6b).

4. Inductive sensor according to claim 3, **characterized in that** the first single coil (7a) and the second single coil (7b) are wound helically.

5. Inductive sensor according to any of claims 1 to 4, **characterized in that** the two winding parts (6a, 6b) are arranged one next to the other in one plane.

6. Cable car system comprising a traction cable (13) and an inductive sensor (1) according to any of claims 1 to 5 for monitoring the position of the traction cable (13).

## Revendications

1. Capteur inductif (1) destiné à surveiller la position d'un câble de transport (13) d'une installation de téléphérique (10), le capteur (1) comprenant une bobine de capteur (3) dotée de deux bornes de bobine (5a, 5b) et une unité d'évaluation de capteur (2) connectée aux deux bornes de bobine (5a, 5b), **caractérisé en ce que** la bobine de capteur (3) est réalisée avec une première partie d'enroulement (6a) et une seconde partie d'enroulement (6b) connectée à celle-ci, la première partie d'enroulement (6a) et la seconde partie d'enroulement (6b) étant enroulées en sens inverse et la première partie d'enroulement (6a) étant connectée à une première borne de bobine (5a) et la seconde partie d'enroulement (6b) étant connectée à une seconde borne de bobine (5b), et **en ce que** la bobine de capteur (3) est conçue pour coopérer avec le câble de transport (13) et l'unité d'évaluation de capteur (2) est conçue pour détecter et évaluer un changement de position du câble de transport (13) par rapport au capteur (1).

2. Capteur inductif selon la revendication 1, **caractérisé en ce que** la bobine de capteur (3) est conçue pour être enroulée en continu en forme de huit.

3. Capteur inductif selon la revendication 1, **caractérisé en ce qu'**une première bobine individuelle (7a), en tant que première partie d'enroulement (6a), est connectée en série à une seconde bobine individuelle (7b), en tant que seconde partie d'enroulement (6b).

4. Capteur inductif selon la revendication 3, **caractérisé en ce que** la première bobine individuelle (7a) et la seconde bobine individuelle (7b) sont enroulées en forme d'hélice.

5. Capteur inductif selon l'une des revendications 1 à 4, **caractérisé en ce que** les deux parties d'enroulement (6a, 6b) sont disposées l'une à côté de l'autre dans un plan.

6. Installation de téléphérique comprenant un câble de transport (13) et un capteur inductif (1) selon l'une des revendications 1 à 5 pour surveiller la position du câble de transport (13).
